## Europäisches Patentamt

## European Patent Office

## Office européen des brevets

(11) Publication number:
**0 260 734**
**B1**

# EUROPEAN PATENT SPECIFICATION

(45) Date of publication of patent specification: **30.01.91**

(21) Application number: **87201561.5**

(22) Date of filing: **18.08.87**

(51) Int. Cl.⁵: **H 01 J 37/20**

(30) Priority: **20.08.86 DE 3628170**

(43) Date of publication of application:
**23.03.88 Bulletin 88/12**

(45) Publication of the grant of the patent:
**30.01.91 Bulletin 91/05**

(84) Designated Contracting States:
**CH DE FR GB LI NL**

(56) References cited:
**DE-A-2 206 545**
**US-A-3 628 013**
**US-A-3 678 270**

(73) Proprietor: **N.V. Philips' Gloeilampenfabrieken**
**Groenewoudseweg 1**
**NL-5621 BA Eindhoven (NL)**

(72) Inventor: **Hoppe, Walter**
**Int. Octrooibureau B.V Prof. Holstlaan 6**
**NL-5656 AA Eindhoven (NL)**

(74) Representative: **Scheele, Edial François**
**INTERNATIONAAL OCTROOIBUREAU B.V. Prof.**
**Holstlaan 6**
**NL-5656 AA Eindhoven (NL)**

(54) Adjustable preparation mounting for a radiation beam apparatus.

Courier Press, Leamington Spa, England.

## Description

The invention relates to an adjustable preparation mounting device for a radiation beam apparatus having a carrier and a movement device for moving a preparation slide for containing a preparation relative to the carrier, the carrier exhibiting a bearing surface for a preparation slide and being provided with a device for holding the preparation slide on the bearing surface, the movement device including actuator elements each of which exhibits a respective coupling part which serves for coupling with the preparation slide and which is movable from a position at a spacing from the preparation slide into engagement with the preparation slide and also, in order to move the preparation slide on the bearing surface, in at least one direction (x, y) parallel to the bearing surface.

A preparation mounting device of the above mentioned kind is known from the US patent 3,628,013.

The development of radiation beam apparatus such as particle radiation microscopes, in particular of electron microscopes, has made great progress during recent years, so far as concerns the simplification of operation and the automation of the various control functions. The preparation mounting devices, which must in general permit an adjustment of the preparation in two directions laying in the preparation place and frequently also a so-called eucentric rotation about an axis of rotation passing perpendicularly through the axis of the beam path of the system, have, however, remained far behind this development.

In many electron microscopes the adjustable preparation mounting is designed as a goniometer, which includes a goniometer rod which is insertable from the side of the microscope. The adjustment of the preparation in one direction, the X direction, is effected by the displacement of the goniometer rod along its axis, while the displacement in the other direction, the Y direction, takes place perpendicular to the longitudinal axis of the rod. The region of the preparation to be observed can be brought into the axis of the beampath of the electron microscope by means of the Y movement, so that it does not move away on tilting of the goniometer rod. A refinement in positioning is achieved by using a preparation slide that is movable relative to the goniometer rod. The movement device, which in the known preparation mounting device comprises a rod and a plunger, can be engaged with the preparation slide by means of a clutch that is actuated by actuator elements in the form of a lever, and can move the preparation slide in a direction parallel to the bearing surface. The actuator elements are each connected by a shaft that is accessible at the exterior of a vacuum chamber of the electron microscope. Actuation of the levers however, requires a relatively complex mechanical transmission, and the number of moving parts of the preparation mounting device is relatively large.

The principal object of the present invention is to simplify an adjustable preparation mounting for a radiation beam apparatus, in particular an electron microscope, to improve its accuracy and temporal constancy, and to permit an automation of the adjustment procedures in a simpler manner than formerly.

To achieve this object, a preparation mounting device in accordance with the invention is characterized in that the actuator element are rod-shaped, are connected at a first end to the carrier, extend by a second end, at which the coupling part is situated, over a region of the bearing surface which serves to bear the preparation slide, and exhibit respective device for moving the second end perpendicular and parallel to the plane of the bearing surface respectively.

The adjustable preparation mounting device, according to the invention, for a particle radiation microscope (i.e. an ion or electron microscope) is simple and accurate, and can be well automated with regard to the control and integrated into existing, especially digital control devices.

According to an advantageous refinement of the invention, which can, moreover, also be employed in adjustable preparation mounting devices other than that according to the invention, the adjustment takes place in combination with an electrical displacement as well as a correlation of the particle-optical image which is generated. This permits an especially accurate adjustment, which can, moreover, also be especially well automated, so that the operation of the microscope is considerably facilitated thereby.

Exemplary embodiments of the invention are explained in greater detail hereinbelow, with reference to the drawings.

In the drawings:

Fig. 1 shows a plan view of a goniometer rod, which is equipped with an adjustable preparation mounting device according to an embodiment of the invention;

Fig. 2 shows an axial cross-section in the direction of the arrows II—II of Fig. 1;

Fig. 3 shows an enlarged representation of an acutator element, in the form in which it is preferably employed in the device according to Figs. 1 and 2;

Fig. 4 shows a plan view of a part of a goniometer rod with an adjustable preparation mounting device according to a second embodiment of the invention;

Fig. 5 shows a plan view of the front end of a goniometer rod with an adjustable preparation mounting device according to a third embodiment of the invention;

Figs. 6 and 7 show diagrams to explain a preferred mode of operation of the device according to Fig. 5.

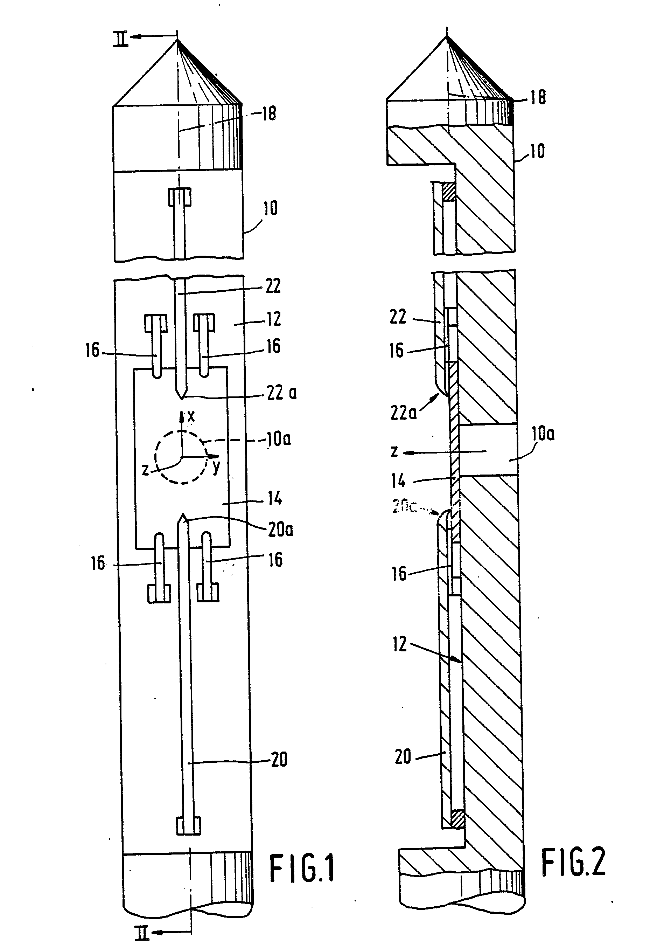

The adjustable preparation mounting device shown in Figures 1 and 2 is mounted on a goniometer rod (10) of a goniometer (not shown) with lateral insertion. The goniometer rod has an aperature (10a) for passage of the particle beam of the microscope. Such goniometers are known, so that a more detailed explanation is unnecessary. It should simply be mentioned that the awkward precision adjustment devices for the goniometer rod which are present in these goniometers can be dispensed with, so that a simple rotatable mounting of the goniometer rod, possibly with the facility of a coarse adjustment in the longitudinal direction and the transverse direction, is sufficient.

The preparation slide of the preparation mounting device is not firmly connected to the goniometer rod, but is movable in a controlled manner relative to the goniometer rod. In the embodiment according to Figs. 1 and 2, the goniometer rod exhibits an plane bearing surface (12), on which a thin preparation slide (14), which is in this instance rfectangular, is mounted by being frictionally held, e.g. by spring fingers (16), which press on the rim of the preparation slide. The longitudinal axis (18) of the goniometer rod (10), about which the latter can, if required, be tilted, extends in the plane of the surface (12) or at a small spacing above the latter, so that the longitudinal axis (18) of the goniometer rod passes through the preparation contained in the preparation slide.

The preparation slide can include a thin metal grid or a carbon foil as carrier structure, and can, if required, be strengthened in the manner of a frame, in order to increase the mechanical strength.

The force exerted by the spring fingers (16) on the preparation slide (14) should be as small as possible and essentially just sufficient to prevent an undesired displacement of the preparation slide on the surface (12). The surface (12) and/or the frame of the preparation mounting slide can be provided with a low-friction surface, e.g. of titanium carbide, as is known for bearings which must operate under conditions encountered in space.

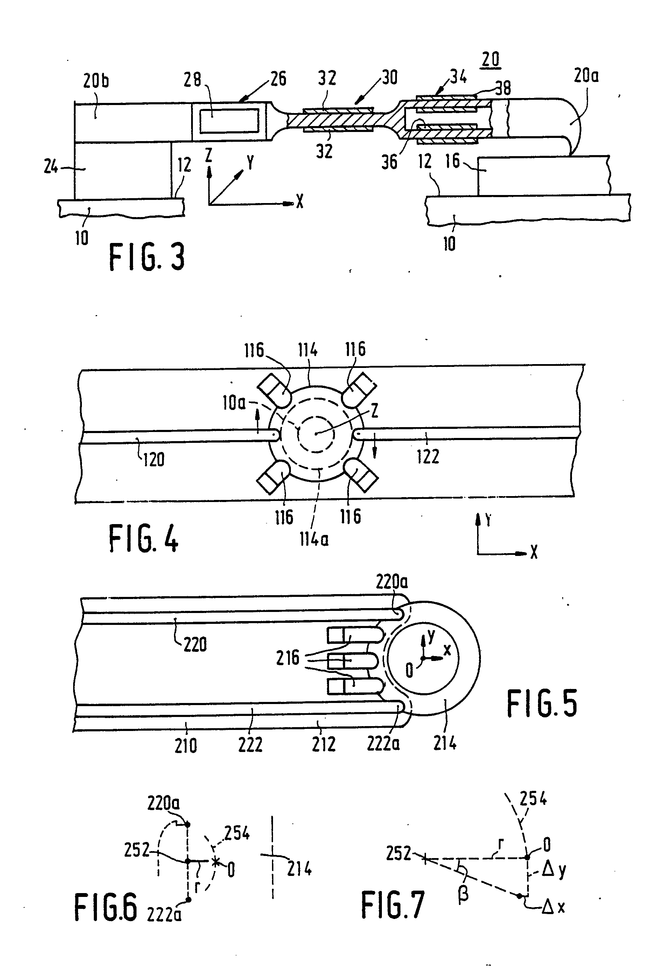

Two actuator elements (20) and (22) are provided for the controlled displacement of the preparation slide (14) against the frictional force generated by the spring fingers (16). A preferred embodiment of the actuator elements will be explained with reference to Figure 3. At the present stage, it is sufficient to state that the front end (20a) or (22a) of the actuator elements (20) or (22), which is provided with a needle-like tip, is movable in a controlled manner in all three directions in space (related to the goniometer rod), i.e. the X direction and the Y-direction, which extend parallel to the bearing surface (12), as well as the Z direction, which extends perpendicular thereto. The stroke of the movement needs to be, in each instance, only in the micrometer range.

In the rest condition, the tapering front ends (20a, 22a) of the actuator elements (20) and (22) are situated at a small spacing above the preparation slide (14). If the preparation is now to be displaced, for example, in the X direction, then in the first instance the front ends of the two actuator elements are moved in the Z direction, until they firly engage at the preparation slide (14). Now, the ends (20a, 22a) of the actuator elements (20) and (22) which engage at the preparation slide (14) are moved in opposite senses in the X direction, for example in that one of the actuator elements is extended and the other is correspondingly contracted. After such a stroke of movement, by which the preparation slide (14) is displaced through a small distance in the X direction against the force of the spring fingers (16), the actuator elements are lifted off again from the preparation slide (14) and brought into their rest condition. If the X displacement is not yet sufficient, the above procedures can be repeated as frequently as desired. Thus, the adjustment device operates in a similar way to a detente drive, but the arresting of the adjusted element does not take place by means of a detente, but by being frictionally held by means of friction due to the pressing force of the spring fingers (16).

For a displacement of the preparation slide in the Y direction, the front ends (20a, 22a) of the actuator elements (20) and (22) are again brought into engagement with the preparation slide (14), and then the front ends are moved in the same sense in the lateral direction (Fig. 1), so that the preparation slide (14) is displaced parallel to the Y direction.

Fig. 3 shows a piezoelectrically operating embodiment of an actuator element. The actuator element (20) shown in Fig. 3 is secured to the goniometer rod (10), at the end (20b) remote from the front end (20a), by means of a mounting block (24). Adjacent to the secured end (20b), the elongate, rod-like actuator element (20) has a first flat piezoelectric part (26), the plane of which extends in the longitudinal direction of the element (20) and perpendicular to the bearing surface (12) and the opposite sides of which are provided with electrodes, of which only one electrode (28) is visible in Fig. 3. The piezoelectric part (26) is designed in such a manner that on application of a voltage difference between the electrodes it bends in such a manner that the end (20a) pivots in the Y direction. The flat piezoelectric part (26) is followed by a second flat piezoelectric part (30), the plane of which extends perpendicular to the plane of the part (26) and parallel to the plane of the surface (12). The piezoelectric part (30) has two electrodes (32) and permits the end (20a) of the actuator element to be moved in the Z direction, i.e. towards the preparation slide (16). Finally, the actuator element (20) also includes a tubular part (34), which is provided, internally and externally, with an electrode (36) and (38) respectively and operates as an electrostrictive element. On application of a voltage of appropriate polarity between electrodes (36) and (38), the tubular part (34) expands or contracts, so that the end (20a) is displaced in corresponding manner in the X direction.

The actuator element which has been described may, of course, be modified in a very wide variety of ways. Thus, for example, in place of a tip, a rough surface can also be provided at the front end, for engagement at the preparation slide; this will above all be expedient in circumstances in which the surface of the preparation slide (16) is relatively uneven. In place of piezoelectric or electrostrictive elements, it is also possible to employ appropriate magnetostrictive elements. The operation of the electron microscope is not disturbed by the magnetic fields which are generated in this case, since the actuator elements are indeed deactuated again after the desired displacement has been achieved.

The fact that the actuator elements are in engagement with the preparation only a displacement does, moreover, have the great advantage that the adjustment device cannot bring about any undesired displacements of the preparation.

Fig. 4 shows an embodiment of the present preparation mounting device which permits the rotation of the preparation. The principal difference from Figs. 1 and 2 consists, in the present instance, in that the preparation slide (114) is circular and preferably exhibits a somewhat broader rim (114a), which may, if required, be mechanically strengthened. The spring fingers (116) are disposed symmetrically about the centre of the preparation slide at angular intervals of 90 degrees, through which centre the axis of the beam path of the system also passes. The actuator element (120, 122) correspond to the actuator elements (20 and (22) in Fig. 2, and can be designed in such a manner as is shown in Fig. 3. With regard to the control, not only in the displacement in the X direction and the Y direction provided, but also a third possibility namely the pivoting of the ends of the actuator elements (120, 122) which engage at the preparation slide (114) diametrically, in the Y direction in opposite senses, as is indicated, for example, by the arrows in Fig. 4. Clearly, this causes a corresponding rotation of the preparation at various angles to the Z axis of the goniometer (perpendicular to the surface (12)), the goniometer rod is tilted through a desired angle, and then the preparation is rotated in steps by means of the actuator elements (120, 122) for the various recordings.

In the embodiments according to Fig. 1 and 2 and Fig. 4, the maximum angle of tilt of the goniometer rod is limited by the dimensions of the bore (10a) of the goniometer rod, which bore is provided for the electron beam. This limitation is not applicable in the case of the embodiment of the device according to the invention which is shown in Fig. 5. The device according to Fig. 5 includes a shortened goniometer rod (210), which ends somewhat in front of the axis of the beam path of the system. The goniometer rod (210) forms a bearing surface (212) corresponding to the surface (12) in Figs. 1 and 2, on which a circular preparation slide (214) is mounted by three spring fingers (216) in such a manner that it freely projects over more than one half of its diameter and the axis of the beam path of the electron microscope passes through its centre.

The device according to Fig. 5 includes two actuator elements (220, 222) which are disposed parallel beside one another and the front ends (220a, 222a) of which are positioned so that they are able to engage at a rim region of the circular preparation slide (214). By means of mutually opposite movement of the ends of the actuator elements which engage at the preparation slide (214), it is clearly possible to effect a rotation of the preparation slide. As can easily be seen, the centre point of a rotation effected in this manner does not, however, coincide with the centre point (O) of the preparation slide (214). As shown in Fig. 6, the centre point (252) of the rotation of the preparation slide (214), that due to a mutually opposite X movement of the actuator element ends (220a, 222a) engaging at the preparation slide (214), in the centre between the engagement points of these ends, so that the centre point (0) of the preparation slide (214) thus povits along a circular arc (254) about (252). As shown in Fig. 7, this undesired pivotal movement can, however, easily be compensated by carrying out an additional corrective adjustment.

Delta $x_R$ = r cos$\beta$ and Delta $y_R$ = r sin$\beta$, where $\beta$ is the angle of pivoting about the fulcrum (252) and r is the spacing between (252) and the centre point. 0 — to be held stationary — of the preparation slide 214. To a good approximation, the angle is equal to arc sin 2x/d, where d represents the spacing of the engagement points at the ends (220a, 222a) from one end and x represents the amount of the X displacement causing the rotation.

In the device according to Fig. 5, the plane of the preparation slide can be tilted, by appropriate rotation of the goniometer rod (214), through a very large angle, possibly up to 80 degrees and above, in relation to the axis of the system, without the occurrence of the risk of shading off the electron beam.

According to a further aspect of the present invention, the above described adjustment procedures are preferably monitored and possibly controlled by correlation. This takes place in that, in the course of an adjustment of the preparation, an image record prior to commencement of the adjustment is correlated with an image generated during the adjustment or after an adjustment step; in this connection, it is possible to employ, for example, an optical correlator such as is described in German Offenlegungsschrifft 3,325,855.

The stressing of the preparation by the particle radiation can be kept small by undertaking the correlation not with the part of the preparation which is to be investigated, but with another part of the preparation or even with the carrier foil. In this procedure, it is possible to operate with a substantially smaller magnification than in the case of the actual recording of the part of the preparation which is of interest, and, in the course of the correlation which is undertaken for the purpose of the adjustment of the preparation, it is then possible to use a relatively coarse-grained carbon foil or a preparation carrier which exhibits a relatively coarse-pored grid with statistically distributed pores. The final fine correlation of the recorded image is then undertaken, in the course of the image processing, in the computer in a known manner.

With carbon foils in the form in which they are conventional as preparation carriers in electron microscopy, an adequate granularity is already shown at magnifications in the range from 80,000 to 200,000, on the basis of which the correlation can be satisfactorily undertaken. With preparation carriers in the form of a grid with to a greater or lesser extent statistically distributed, large pores, the correlation can, if required, be undertaken even at magnifications of 500 times to 1,000 times.

In the case of a displacement in the X direction, let the maximum of the correlation function arising be displaced, for example, from left to right. It is now possible to define easily by the correlation function a path which is intended to correspond to a desired path in steps. This can take place, for example, in the following manner: the image generated by the electron microscope is displaced electrically in a known manner, until the correlation maximum reaches, for example, the left-hand border of the correlation region. A signal is then emitted, and the displacement is deacutated. The X-displacement of the existing adjustment device is now actuated until such time as the correlation maximum reaches the righthand border. After deactuation of the adjustment device, the image is now again displaced electrically, until the correlation maximum is again situated at the left-hand border, and subsequently the existing adjustment device is again set into operation. It is possible, at any time, i.e. from one adjustment step to the next, to displace the image electronically to any desired extent and to view the image, which is very important. The is leads, in principle, to a practically continuous image displacement; in this connection, the observer does not need to know at all when the image is electronically displaced and when it is mechanically displaced. The unavoidable inaccuracies of the adjustment may also be compensated by correlation, in that the actuator elements are controlled in such a manner that the correlation function changes only in the desired manner in the course of an adjustment.

The monitoring of the adjustment of the preparation with reference to the correlation function is important, especially in the course of a rotation of the preparation, as has been explained with reference to Figs. 4 and 5. Shifts of the centre of rotation may be avoided, without difficulties, by an opposing control with the aid of the correlation function.

It is plausible that an adjustment of the preparation carrier can take place simultaneously in several coordinate directions. For example, displacements in the X direction and/or the Y direction and/or rotations can be combined.

## Claims

1. Adjustable preparation mounting device for a radiation beam apparatus having a carrier and a movement device for moving a preparation slide for containing a preparation relative to the carrier, the carrier (10) exhibiting a bearing surface (12) for a preparation slide (14) and being provided with a device (16) for holding the preparation slide (14) on the bearing surface (12), the movement including actuator elements (20, 22) each of which exhibits a respective coupling part (20a, 22a) which serves for coupling with the preparation slide (14) and which is movable from a position at a spacing from the preparation slide into engagement with the preparation slide and also, in order to move the preparation slide on the bearing surface, in at least one direction (x, y) parallel to the bearing surface (12), characterized in that the actuator elements (20, 22) are rod-shaped, are connected at a first end (20b) to the carrier (10), extend by a second end (20a, 22a), at which the coupling part is situated, over a region of the bearing surface (12) which serves to bear the preparation slide, and exhibit respective device (26, 30) for moving the second end perpendicular and parallel to the plane of the bearing surface (12) respectively.

2. Device according to Claim 1, characterized in that the coupling part (20a, 22a) is movable in two different directions (X, Y) which preferably extend substantially perpendicular to one another and which are parallel to the bearing surface.

3. Device according to Claims 1 and 2, characterized in that the movement devices (26, 30, 34) are piezoelectric devices.

4. Device according to Claims 1 and 2, characterized in that the movement devices are magnetic devices.

5. Device according to one of the preceding Claims, characterized in that the carrier (10) has substantially the shape of a goniometer rod designed for a lateral introduction into the radiation beam apparatus, and in that the bearing surface (12) passes substantially through the axis (18) of the goniometer rod.

6. Device according to one of the preceding Claims, characterized in that the preparation slide (114, 214) is round, and in that the actuator elements (120, 122; 220, 222) are adjustable in opposite directions in order to rotate the preparation slide (114, 214).

7. Device according to Claim 6, characterized in that the actuator elements (120, 122) engage at diametrically opposite sides of the preparation slide (114) and are laterally pivotable in opposite directions (Fig. 4).

8. Device accordinag to Claim 6, characterized in that the carrier (210) is a shortened goniometer rod, which ends at a spacing in front of the axis of the beam path of the microscope; in that the preparation slide (214) is susbtantially circular; in that the device (216) for holding the preparation slide (214) permits the latter to be held in such a manner that more than one half of its diameter projects from the end of the carrier (210) to such an extent that the axis of the beam path passes through a central region of the preparation slide (214); and in that the actuator elements (220, 222) are disposed parallel beside one another at the carrier and extend over spaced parts of the rim of the preparation slide (214) (Fig. 5).

9. Device according to Claim 8, characterized in that the ends (220a, 222a) of the actuator elements (220, 222), which ends engage at the rim of the preparation slide (214), are adjustable in opposite directions in their longitudinal direction and are also adjustable, in dependence upon the amount of the mutually opposite adjustment (x), in the same sense in the longitudinal direction (X direction) as well as in a direction (Y direction) which is parallel to the bearing surface and perpendicular to the longitudinal direction.

10. Process for the operation of an adjustable preparation mounting device according to any one of the preceding claims, characterized in that the monitoring and/or control of the adjustment takes place by correlation of a reference radiation image with at least one radiation image recorded during or after adjustment.

11. Process according to Claim 10, characterized in that a radiation image of changed particles in the apparatus is electrically displaced in such a manner that the maximum of the correlation function is situated at a boundary of a predetermined correlation region, and in that the adjustment device is then operated until such time as the correlation maximum reaches the opposite boundary of the pertinent region.

12. Process according to Claim 10 or 11, characterized in that the correlation serving for the control of the adjustment of the preparation is carried out with a region of the preparation/preparation carrier arrangement which is situated outside the preparation region to be investigated.

13. Process according to Claim 10, 11 or 12, characterized in that the correlation serving for the control of the preparation adjustment is carried out with smaller magnification than is employed in the recording of the preparation region concerned.

14. Process according to Claims 10 to 13, characterized in that a relatively coarsely structured preparation carrier, such as a coarse-grain carbon foil or a grid structure with statistically distributed pores, is employed.

**Patentansprüche**

1. Justierbarer Präparathalter für ein Strahlungsbündelgerät mit einem Träger und einer Vorschubeinrichtung zum Verlagern eines Präpartsschlittens in bezug auf den Träger (10) für die Aufnahme eines Präparats, der eine Tragfläche (12) für einen Präparatsschlitten (14) besitzt und mit einer Einrichtung (16) zum Festhalten des Präparatsschlittens (14) auf der Tragfläche (12) ausgerüstet ist, wobei die Vorschubeinrichtung Betätigungselemente (20, 22) enthält, die je einen Koppelteil (20a, 22a) besitzen, der die Kopplung mit dem Präparatsschlitten (14) versorgt und aus einer Stellung im Abstand vom Präparatsschlitten in Eingriff mit dem Präparatsschlitten verschiebbar ist und weiter die Verlagerung des Präparatsschlittens über die Tragfläche wenigstens in einer Richtung (x, y) parallel zur Tragfläche (12) versorgt, dadurch gekennzeichnet, daß die Betätigungselemente (20, 22) stabförmig und bei einem ersten Ende (20b) am Träger befestigt sind, sich bis zu einem zweiten Ende (20a, 22a), an dem sich der Koppelteil befindet, über eine Strecke der Tragfläche (12) erstrecken, die zum Tragen des Präparatsschlittens dient, und jeweilige Einrichtungen (26, 30) zum Verschieben des zweiten Endes senkrecht bzw. parallel zur Ebene der Tragfläche (12) aufweisen.

2. Halter nach Anspruch 1, dadurch gekennzeichnet, daß der Koppelteil (20a, 22a) in zwei verschiedenen Richtungen (X, Y) verschiebbar ist, die im wesentlichen senkrecht zueinander und parallel zur Tragfläche verlaufen.

3. Halter nach Anspruch 1 und 2, dadurch gekennzeichnet, daß die Verlagerungseinrichtungen (26, 30, 34) piezoelektrische Einrichtungen sind.

4. Halter nach Anspruch 1 und 2, dadurch gekennzeichnet, daß die Verlagerungseinrichtungen magnetische Einrichtungen sind.

5. Halter nach einem oder mehreren der vorangehenden Ansprüche, dadurch gekennzeichnet, daß der Träger (10) im wesentlichen die Form eines Goniometerstabes besitzt, der für seitliche Einführung in das Stahlungsbündelgerät ausgelegt ist, und daß die Tragfläche (12) im wesentlichen durch die Achse (18) des Goniometerstabes geht.

6. Halter nach einem oder mehreren der vorangehenden Ansprüche, dadurch gekennzeichnet, daß der Präparatsschlitten (114, 214) rund ist, und daß die Betätigungselemente (120, 122; 220, 222) zum Drehen des Präparatsschlittens (114, 214) in entgegengesetzten Richtungen justierbar sind.

7. Halter nach Anspruch 6, dadurch gekennzeichnet, daß die Betätigungselemente (120, 122) an einander diametral gegenüberliegenden Seiten des Präparatsschlittens (114) angreifen und in entgegengesetzten Richtungen seitwärts drehbar sind (Fig. 4).

8. Halter nach Anspruch 6, dadurch gekennzeichnet, daß der Träger (210) ein gekürzter Goniometerstab ist, der im Abstand vor der Achse des Bündelweges des Mikroskops endet; daß der Präparatsschlitten (214) im wesentlichen kreisförmig ist; daß der Halter (216) zum Festhalten des Präparatsschlittens (214) diesen Schlitten derart festhalten kann, daß mehr als eine Hälfte seines Durchmessers aus dem Ende des Trägers (210) soweit herausragt, daß die Achse des Bündelweges durch ein zentrales Gebiet des Präparatsschlittens (214) geht, und daß die Betätigungselemente (220, 222) am Träger parallel nebeneinander angeordnet sind und sich über im Abstand voneinander liegende Abschnitte des Randes des Präparatsschlittens (214) erstrecken (Fig. 5).

9. Halter nach Anspruch 8, dadurch gekennzeichnet, daß die beim Rand des Präparatsschlittens (214) angreifenden Enden (220a, 222a) der Betätigungselemente (220, 222) in entgegengesetzten Richtungen in ihrer Längsrichtung sowie auch in Abhängigkeit vom Betrag der einander entgegengesetzten Justierungen (x) sowohl in der Längsrichtung (X-Richtung) als auch in einer Richtung (Y-Richtung) justierbar sind, die parallel zur Tragfläche und senkrecht zur Längsrichtung verläuft.

10. Verfahren zum Betreiben eines justierbaren Präparathalters nach einem oder mehreren der vorangehenden Ansprüche, dadurch gekennzeichnet, daß die Überwachung und/oder Steuerung der Justierung durch Korrelation eines Bezugs-Strahlungsbildes mit wenigstens einem während oder nach der Justierung aufgezeichneten Strahlungsbild erfolgt.

11. Verfahren nach Anspruch 10, dadurch gekennzeichnet, daß ein Strahlungsbild geänderter Teilchen im Gerät derart elektrisch verschoben wird, daß das Maximum der Korrelationsfunktion sich an einer Begrenzung eines vorgegebenen Korrelationsgebiets befindet, und daß die Justiereinrichtung dabei eine Zeitlang betrieben wird, bis das Korrelationsmaximum die gegenüberliegende Begrenzung des einschlägigen Gebiets erreicht.

12. Verfahren nach Anspuch 10 oder 11, dadurch gekennzeichnet, daß die zur Justierungssteuerung des Präparats dienende Korrelation mit einem Gebiet der Präparat/Präparatträger-Einrichtung durchgeführt wird, das außerhalb des zu untersuchenden Präparatgebiets leigt.

13. Verfahren nach Anspruch 10, 11 oder 12, dadurch gekennzeichnet, daß die zur Justierungssteuerung des Präparats dienende Korrelation mit einer geringeren Vergrößerung als bei der Aufzeichnung des untersuchten Präparatgebiets erfolgt.

14. Verfahren nach Anspruch 10 bis 14, dadurch gekennzeichnet, daß ein verhältnismäßig grobstrukturierter Präparatträger verwendet wird, wie zum Beispiel ein Grobkorn-Kohlenstoff-Film oder eine Gitterstruktur mit statistisch verteilten Poren.

## Revendications

1. Monture ajustable pour la préparation dans un appareil à faisceau de rayonnement comportant un support et un dispositif de déplacement pour déplacer une lame porte-objet afin de positionner une préparation par rapport au support, le support (10) présentant une surface d'appui (12) pour une lame porte-objet (14) et étant pourvu d'un dispositif (16) pour maintenir la lame porte-objet (14) sur la surface d'appui (12), le dispositif de déplacement comprenant des éléments actionneurs (20, 22) qui comportent chacun une pièce d'accouplement respective (20a, 22a) qui sert à assurer l'accouplement à la lame (14) et qui peut être déplacée à partir d'une position espacée de cette lame, pour l'amener en contact avec celle-ci et aussi pour déplacer la lame porte-objet sur la surface d'appui, dans au moins une direction (X, Y) parallèle à cette surface d'appui (12), caractérisée en ce que les éléments actionneurs (20, 22) ont la forme de tiges, sont reliés à une première extrémité (20b) au support (10), s'étendent par une seconde extrémité (20a, 22a), à laquelle est située la pièce d'accouplement, au-dessus d'une région de la surface d'appui (12) qui est destinée à supporter la lame porte-objet, et présentent un dispositif respectif (26, 30) pour déplacer la seconde extrémité perpendiculairement et parallèlement au plan de la surface d'appui (12).

2. Dispositif suivant la revendication 1, caractérisé en ce que la pièce d'accouplement (20a, 22a) est mobile dans deux directions différentes (X, Y) qui s'étendent de préférence en substance perpendiculairement l'une à l'autre et qui sont parallèles à la surface d'appui.

3. Dispositif suivant les revendications 1 et 2, caractérisé en ce que les dispositifs de déplacement (26, 30, 34) sont des dispositifs piézoélectriques.

4. Dispositif suivant la revendications 1 et 2, caractérisé en ce que les dispositifs de déplacement sont des dispositifs magnétiques.

5. Dispositif suivant l'une quelconque des revendications précédentes, caractérisé en ce que le support (10) a en substance la forme d'une broche de goniomètre conçue pour être introduite par le côté de l'appareil à faisceau de rayonnement et que la surface d'appui (12) passe en substance par l'axe (18) de la broche de goniomètre.

6. Dispositif suivant l'une quelconque des revendications précédentes, caractérisé en ce que la lame porte-objet (114, 214) est ronde et que les éléments actionneurs (120, 122; 220, 222) sont ajustables en sens opposés pour faire tourner la lame porte-objet (114, 214).

7. Dispositif suivant la revendication 6, caractérisé en ce que les éléments actionneurs (120, 122) attaquent des côtés diamétralement opposés de la lame porte-objet (114) et peuvent pivoter latéralement en sens opposés (Fig. 4).

8. Dispositif suivant la revendication 6, caractérisé en ce que le support (210) est une broche de goniomètre raccourcie qui se termine à une certaine distance en avant de l'axe du trajet du faisceau du microscope, que la lame porte-objet (214) est en substance circulaire, que le dispositif (216) destiné à maintenir la lame porte-objet (214) permet à cette dernière d'être maintenue d'une mainière telle que plus de la moitié de son diamètre dépasse de l'extrémité du support (210), dans une mesure telle que l'axe du trajet du faisceau passe par une région centrale de la lame porte-objet (214) et que les éléments actionneurs (220, 222) sont disposés parallèlement l'un à côté de l'autre au niveau du support et s'étendent au-dessus de parties espacées du bord de la lame porte-objet (214) (Fig. 5).

9. Dispositif suivant la revendication 8, caractérisé en ce que les extrémités (220a, 222a) des éléments actionneurs (220, 222) qui attaquent le bord de la lame porte-objet (214) peuvent être ajustées en sens opposés dans leur direction longitudinale et peuvent également être ajustées, en fonction du degré d'ajustement réciproquement opposé (X), dans le même sens dans la direction longitudinale (direction X), ainsi que dans une direction (direction Y) qui est parallèle à la surface d'appui et perpendiculaire à la direction longitudinale.

10. Procédé de conduite d'une monture ajustable pour la préparation suivant l'une quelconque des revendications précédentes, caractérisé en ce que la surveillance et/ou la commande de l'ajustements s'effectuent par corrélation d'une image de rayonnement de référence avec au moins une image de rayonnement enregistrée pendant ou après l'ajustement.

11. Procédé suivant la revendication 10, caractérisé en ce qu'une image de rayonnement de particules chargées dans l'appareil est déplacée électriquement d'une manière telle que le maximum de la fonction de corrélation soit situé à une limite d'une région de corrélation prédéterminée et que le dispositif d'ajustement est alors actionné jusqu'à ce que le maximum de corrélation atteigne la limite opposée de la région intéressante.

12. Procédé suivant la revendication 10 ou 11, caractérisé en ce que la corrélation servant à commander l'ajustement de la préparation est effectuée avec une région de l'ensemble de la préparation et du support de préparation qui est située en dehors de la région de préparation à examiner.

13. Procédé suivant la revendication 10, 11 ou 12, caractérisé en ce que la corrélation servant à la commande de l'ajustement de la préparation est effectuée avec un grossissement inférieur à celui qui est utilisé dans l'enregistrement de la région de préparation en question.

14. Procédé suivant l'une quelconque des revendications 10 à 13, caractérisé en ce qu'un support de préparation de structure relativement grossière, par exemple une feuille mince de carbone à grains grossiers ou une structure réticulée à répartition statistique des pores, est utilisé.

EP 0 260 734 B1

FIG.1

FIG.2

FIG. 3

FIG. 4

FIG. 5

FIG.6

FIG.7